# EUROPEAN PATENT APPLICATION

(11) **EP 4 794 487 A1**
(43) Date of publication of application: **19.08.2026**
(21) Application number: 24876822.8
(22) Date of filing: 12.11.2024
(51) Int. Cl.: H10F 71/00, H10F 19/00

(54) **SOLAR CELL MANUFACTURING APPARATUS AND SOLAR CELL MANUFACTURING METHOD**

(30) Priority: 11.10.2023 KR 20230134843
(71) Applicant: Hanwha Solutions Corporation, Seoul 04541 (KR)
(72) Inventor: JUNG, Min Kyo, Seoul 04541 (KR); BAEK, Dong Heon, Seoul 04541 (KR); JEON, Sung Gyu, Seoul 04541 (KR); CHUNG, Dong Jin, Seoul 04541 (KR)
(74) Representative: Mooser, Sebastian Thomas
(86) International application number: PCT/IB2024/061211
(87) International publication number: WO 2025/079056

(57) **Abstract**

A solar cell manufacturing apparatus includes a base conveying a stage on which a solar cell is seated while supporting the stage; and a curing unit disposed above the base and formed to have a hollow space open at a lower side thereof to partially cover an upper side of the base, wherein the base comprises a first heater disposed on an upper surface thereof, the curing unit comprises a second heater disposed on an interior ceiling of the curing unit, the stage having the solar cell seated thereon is conveyed between the first heater and the second heater, and a first length of the first heater is longer than a second length of the second heater, each of the first and second lengths being a length in a first direction corresponding to a conveying direction of the solar cell.

## Description

### [Technical Field]

Embodiments of the present invention relate to a solar cell manufacturing apparatus and a solar cell manufacturing method.

### [Background Art]

A solar cell is formed by disposing a diode having a p-n junction on a substrate. When sunlight reaches a solar cell, the solar cell creates an exciton, that is, an electron-hole pair, and the exciton splits into electrons and holes, which migrate to an n-layer and to a p-layer, respectively, thereby generating photovoltaic electricity across the p-n junction. Tabbing refers to a process of forming a single solar cell module through electrical connection of multiple solar cells to one another by placing wires on the solar cells.

Here, a process of bonding the solar cells and the wires includes applying an electrically conductive adhesive (ECA) to the surfaces of the solar cells and bonding the wires to the solar cells.

The process of bonding the solar cells to the wires using the electrically conductive adhesive is a next generation process for manufacturing solar cells and various studies have been conducted on specific embodiments thereof.

### [Disclosure]

### [Technical Problem]

It is an object of the present invention to provide a solar cell manufacturing apparatus and a solar cell manufacturing method including a process of bonding a solar cell and a wire using an adhesive.

The above object is provided by way of example and the present invention is not limited thereto.

### [Technical Solution]

1. One aspect of the present invention relates to a solar cell manufacturing apparatus. The solar cell manufacturing apparatus includes: a base conveying a stage on which a solar cell is seated while supporting the stage; and a curing unit disposed above the base and formed to have a hollow space open at a lower side thereof to partially cover an upper side of the base, wherein the base includes a first heater disposed on an upper surface thereof, the curing unit includes a second heater disposed on an interior ceiling of the curing unit, the stage having the solar cell seated thereon is conveyed between the first heater and the second heater, and a first length of the first heater is longer than a second length of the second heater, each of the first and second lengths being a length in a first direction corresponding to a conveying direction of the solar cell.
2. In embodiment 1, the base may include a curing zone in which a curing process is performed with the solar cell seated on the stage; and a pre-heating zone in which the stage having the solar cell seated thereon is pre-heated before entering the curing zone, the first heater may be disposed in the curing zone and in the pre-heating zone, and the second heater may be disposed in the curing zone.
3. In embodiment 2, the base may further include an outlet zone, to which the stage having the solar cell seated thereon is conveyed from the curing zone, and the first heater may be disposed in the curing zone, the pre-heating zone, and the outlet zone.
4. In embodiment 2, the pre-heating zone may have a width corresponding to a width of the stage.
5. In embodiment 2, the base may further include a solar cell seating zone in which the solar cell is seated on the stage, and the solar cell seating zone may have a width corresponding to a width of the stage and may be spaced apart from the pre-heating zone by a first distance.
6. In embodiment 5, the base may further include a jig securing zone in which an upper surface of the solar cell seated on the stage is secured to the stage by a jig, the jig securing zone having a width corresponding to the width of the stage and being disposed between the pre-heating zone and the solar cell seating zone.
7. In embodiment 5, the base may further include a stage feeding zone in which the stage is fed to the base, the stage feeding zone being connected to the solar cell seating zone, and a stage feeder may feed the stage to the stage feeding zone while being lifted or lowered in the stage feeding zone.
8. In embodiment 7, the base may further include a wire feeding zone in which a wire is fed to the stage feeding zone and the solar cell seating zone, the wire feeding zone being provided with a wire feeder to feed the wire to the stage in the stage feeding zone.
9. In embodiment 1, the first heater may be disposed at a location facing a lower surface of the solar cell to cure the lower surface of the solar cell and the second heater may be disposed at a location facing an upper surface of the solar cell to cure the upper surface of the solar cell.
10. Another aspect of the present invention relates to a solar cell manufacturing method. The solar cell manufacturing method includes: feeding a stage to a solar cell manufacturing apparatus; feeding a wire onto the stage; feeding a solar cell and a jig onto the stage fed the wire; pre-heating the solar cell and the jig on the stage; curing the solar cell and the jig on the stage; and discharging the solar cell.
11. In embodiment 10, the solar cell manufacturing apparatus may include: a base conveying the stage while supporting the stage and including a first heater disposed on an upper surface thereof; and a curing unit including a second heater, the stage may be conveyed between the first heater and the second heater, the solar cell and the jig may be pre-heated by the first heater in the step of pre-heating, and the solar cell and the jig may be cured by the first and second heaters in the step of curing.
12. In embodiment 10, the method may further include post-heating the solar cell and the jig on the stage after the step of curing.
13. In embodiment 10, the method may further include retrieving the jig after the step of post-heating.
14. In embodiment 10, the method may further include retrieving the stage after the step of post-heating.

The above and other aspects, features, and advantages of the present invention will become apparent from the detailed description, claims, and drawings for practicing the invention.

### [Advantageous Effects]

In a solar cell manufacturing apparatus and a solar cell manufacturing method according to embodiments of the present invention, the curing zone is formed in a structure capable of accommodating a plurality of stages each having a solar cell seated thereon as much as possible, thereby reducing a tact time in a curing process.

In addition, in the solar cell manufacturing apparatus and the solar cell manufacturing method according to the embodiments of the present invention, a pre-heating zone in which a first heater is disposed is spaced apart a first distance from a solar cell seating zone in which the solar cell is seated on a stage and a wire is fed, thereby preventing the solar cell from being cured before the wire and a jig are placed on the solar cell.

Further, in the solar cell manufacturing apparatus and the solar cell manufacturing method according to the embodiments of the present invention, a first heater having a greater length than a second heater of the curing unit is disposed on the base, and a solar cell disposed at a location where the first heater extending beyond the second heater is disposed enters the curing zone after being pre-heated by the first heater in a pre-heating zone, thereby improving quality of the solar cell according to the curing process.

The effects of the present invention are not limited to the aforementioned effects and other effects not mentioned will become apparent to those skilled in the art from the claims.

### [Description of Drawings]

FIG. 1 is an overall conceptual view of a solar cell manufacturing apparatus according to one embodiment of the present invention.
FIG. 2 is a diagram sequentially illustrating a process of connecting solar cells and wires according to one embodiment of the present invention.
FIG. 3 is a perspective view of a solar cell manufacturing apparatus including a curing unit according to one embodiment of the present invention.
FIG. 4 is a perspective view of the solar cell manufacturing apparatus including the curing unit according to one embodiment of the present invention, illustrating a stage placed therein.
FIG. 5 is a bottom view of Part A1 of FIG. 4, that is, the curing unit.
FIG. 6 is a top view of Part A2 of FIG. 4, that is, a base.
FIG. 7 is an enlarged view of Part B of FIG. 4.
FIG. 8 is a cross-sectional view taken along line C-C of FIG. 4.
FIG. 9 is a flowchart illustrating a solar cell manufacturing method according to one embodiment of the present invention.

### [Best Mode]

The present invention can be modified in various ways and can have various embodiments, some of which are illustrated in the drawings and described in detail in the following description of the invention. However, it should be understood that it is not intended to limit the present invention to any particular embodiments and the present invention includes all modifications, equivalents, or substitutions that fall within the scope of the present invention. In description of the invention, the same components will be denoted by the same reference numerals throughout the specification.

Hereinafter, exemplary embodiments of the present invention will be described in detail with reference to the accompanying drawings, in which the same or corresponding components will be denoted by the same reference numerals and repeated description thereof will be omitted.

In the following embodiments, the terms "first", "second", and the like are not intended to be limiting, but are used to distinguish one element from another element.

In the following embodiments, the singular forms "a", "an" and "the" are intended to include the plural forms as well, unless the context clearly indicates otherwise.

In the following embodiments, the terms "includes," "including," "comprises," and/or "comprising," when used in this specification, specify the presence of stated features or components but do not preclude the presence or addition of one or more other features or components.

In the drawings, dimensions of various elements, layers, etc. may be exaggerated or reduced for clarity of illustration. For example, the size and thickness of each element shown in the drawings is arbitrarily shown for ease of description and the present invention is not limited thereto.

When an exemplary embodiment is implemented differently, a specific process order may be performed differently from the described order. For example, two consecutively described processes may be performed substantially at the same time or performed in an order opposite the described order.

The terminology used herein is for the purpose of describing particular embodiments and is not intended to be limiting. Moreover, the terms "includes," "including," "comprises," and/or "comprising," when used in this specification, specify the presence of stated features, integers, steps, operations, elements, components and/or groups thereof but do not preclude the presence or addition of one or more other features, integers, steps, operations, elements, components, and/or groups thereof.

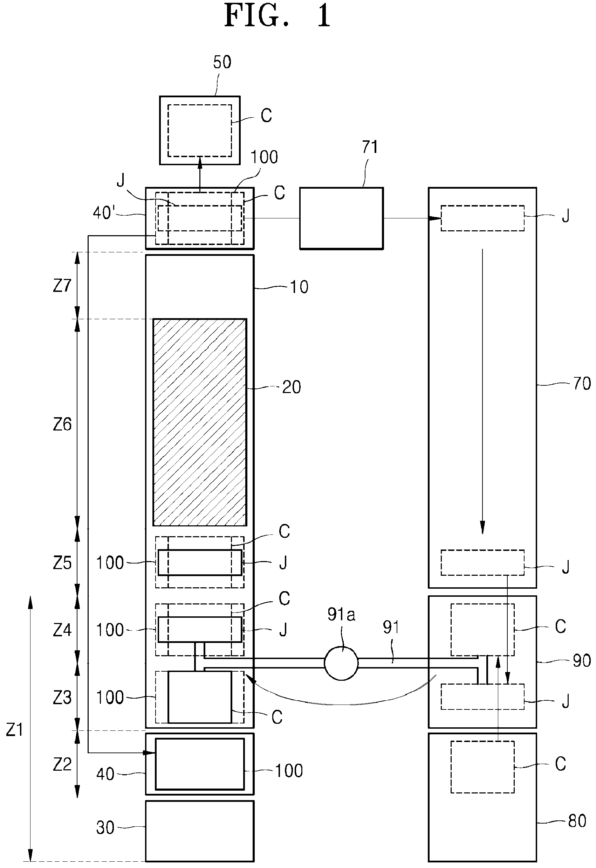

Hereinafter, a solar cell manufacturing apparatus according to one embodiment of the present invention will be described with reference to FIG. 1 to FIG. 8.

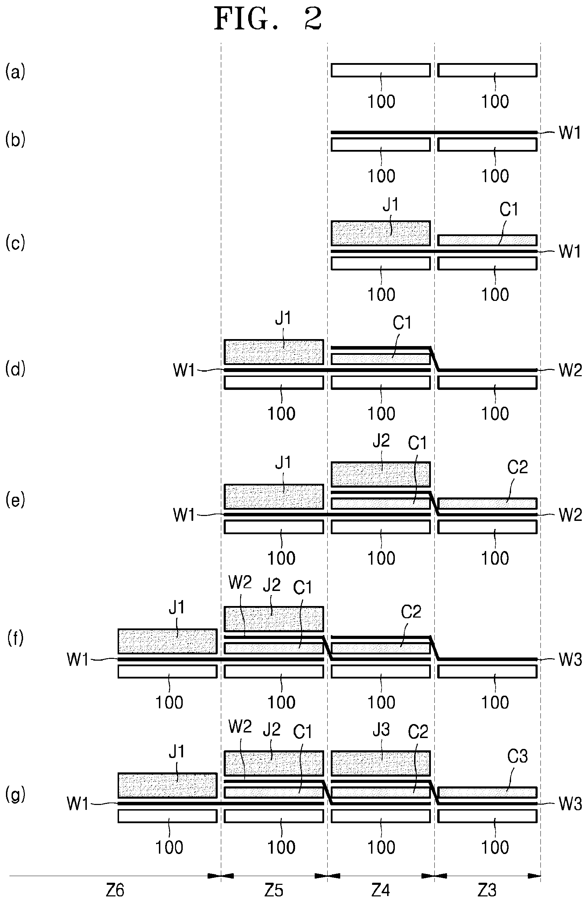

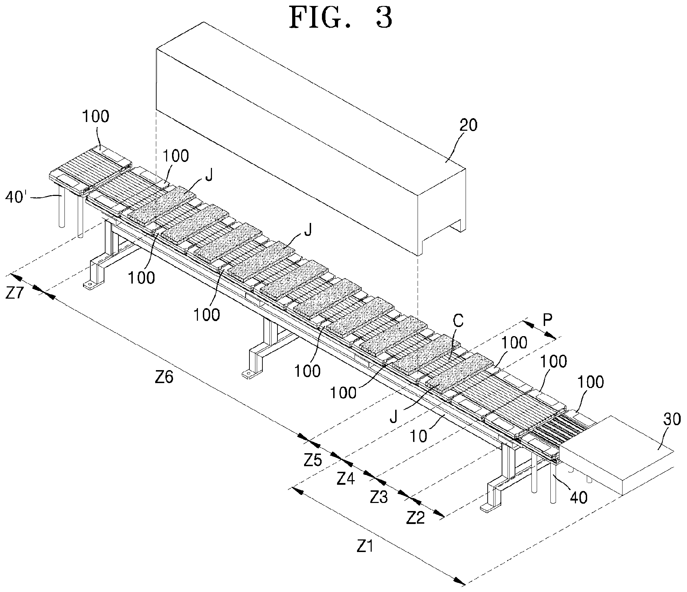

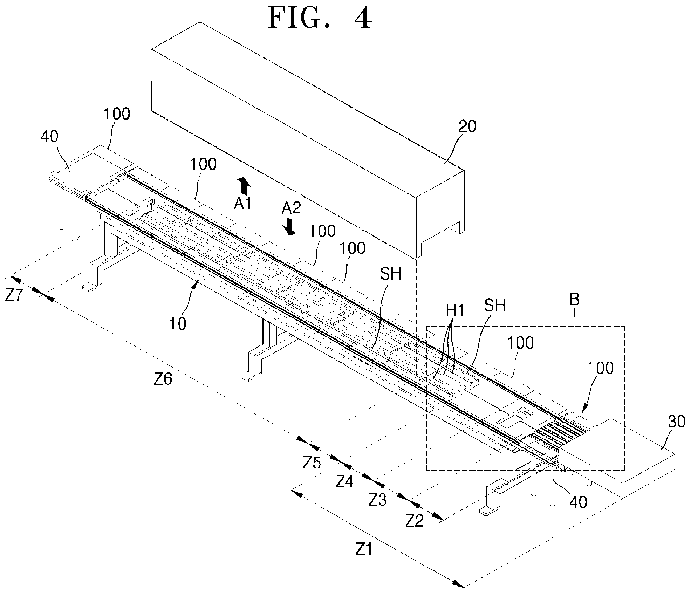

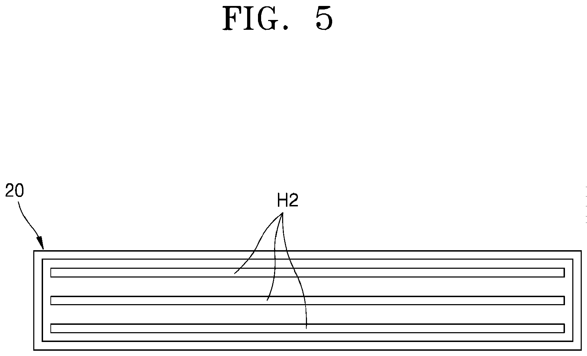

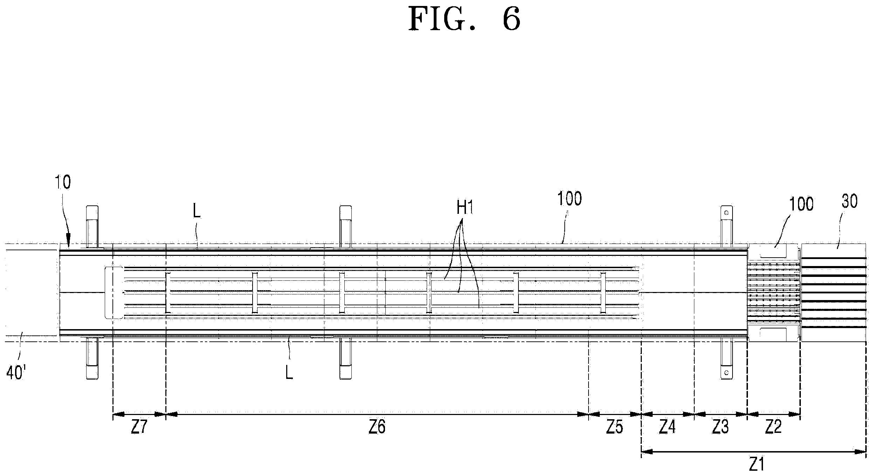

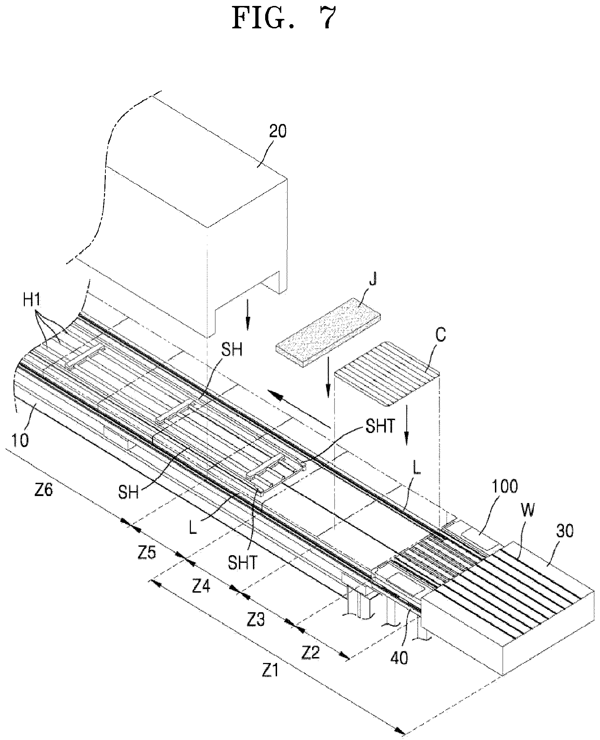

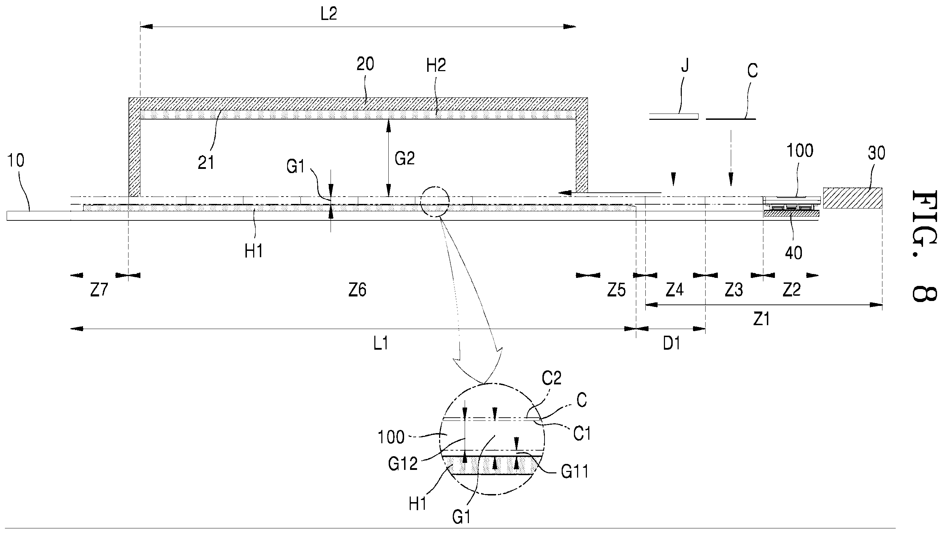

FIG. 1 is an overall conceptual view of a solar cell manufacturing apparatus according to one embodiment of the present invention. FIG. 2 is a diagram sequentially illustrating a process of connecting solar cells and wires according to one embodiment of the present invention. FIG. 3 is a perspective view of a solar cell manufacturing apparatus including a curing unit according to one embodiment of the present invention. FIG. 4 is a perspective view of the solar cell manufacturing apparatus including the curing unit according to one embodiment of the present invention, illustrating a stage placed therein. FIG. 5 is a bottom view of Part A1 of FIG. 4, that is, the curing unit. FIG. 6 is a top view of Part A2 of FIG. 4, that is, a base. FIG. 7 is an enlarged view of Part B of FIG. 4. FIG. 8 is a cross-sectional view taken along line C-C of FIG. 4.

A solar cell manufacturing apparatus is a device for connecting solar cells C and a wire w to form a solar cell module. The solar cell C includes a semiconductor junction region having a p-n junction surface, and when irradiated with a certain magnitude or more of energy, the solar cell C generates electromotive force to convert light energy into electrical energy. A semiconductor material included in the solar cell C is not limited to a particular material and may include silicon (monocrystalline, polycrystalline, and amorphous silicon), gallium arsenide, cadmium telluride, cadmium sulfide, indium phosphorus, copper indium gallium selenide (CIGS), organic dyes, or mixtures thereof.

The wire w is a conductor for electrically connecting a plurality of solar cells C to each other and is configured to connect front and back surfaces of adjacent solar cells C to each other. For example, the wire w may be electrically connected to the solar cells C through a curing process. Alternatively, the wires w may be electrically connected to the solar cells C through an electrically conductive adhesive (ECA).

Referring to FIG. 1 to FIG. 8, the solar cell manufacturing apparatus according to the embodiment of the present invention includes: a base 10 conveying a stage 100, on which a solar cell C is seated, while supporting the stage; and a curing unit 20 disposed above the base 10 and formed to have a hollow space open at a lower side thereof to partially cover an upper side of the base 10, wherein the base 10 includes a first heater H1 disposed on an upper surface thereof, the curing unit 20 includes a second heater H2 disposed on an inner ceiling 21 of the curing unit 20, the stage 100 is conveyed together with the solar cell C seated thereon between the first heater H1 and the second heater H2, and a first length L1 of the first heater H1 is longer than a second length L2 of the second heater H2.

Referring to FIG. 1, a curing process may be performed while the solar cells C pass through the curing unit 20 with each of the solar cells C seated on the stage 100. The solar cells C may be fed through a cell feeder 80. The cell feeder 80 may feed the solar cells C with an electrically conductive adhesive (ECA) applied thereto.

The cell feeder 80 may convey the solar cells C with the electrically conductive adhesive applied thereto to a cell-jig feeder 90. In addition, a jig feeder 70 may be disposed at a side opposite the cell feeder 80 with reference to the cell-jig feeder 90 to feed jigs J to the cell-jig feeder 90.

The cell-jig feeder 90 may convey the solar cell C and the jig J to the upper side of the base 10 through a cell-jig conveying unit 91. The cell-jig conveying unit 91 may grip the solar cell C and the jig J together and may rotationally shift the solar cell C and the jig J around a rotational shaft 91a to place the solar cell C and the jig J on the upper side of the base 10. Then, the solar cell C and the jig J disposed on the upper side of the base 10 may be sequentially seated on the stage 100, which in turn may enter a curing zone Z6 together with the solar cell C and the jig J seated thereon to be subjected to the curing process.

A stage feeding zone Z2 may be provided with a stage feeder 40. The stage feeder 40 may feed the stage 100 to the stage feeding zone Z2. The solar cell C and the jig J may be seated on the stage 100 fed to the stage feeding zone Z2 and the stage 100 may pass through the curing zone Z6 together with the solar cell C and the jig J seated thereon to allow the curing process for the solar cell C to be performed.

On the stage 100 having passed through the curing zone Z6 and an outlet zone Z7 described below, the jig J may be separated and retrieved from the stage 100 and the solar cell C by a jig retrieval unit 71. The solar cell C seated on the stage 100 from which the jig J is separated may be separated and discharged from the stage 100 through a cell conveying unit 50. The jig retrieval unit 71 may feed the retrieved jig to the jig feeder 70, which in turn may refeed the retrieved jig to the cell-jig feeder 90.

The stage 100 from which the jig J and the solar cell C are separated may be retrieved by a stage retrieval unit 40'. The stage retrieval unit 40' is connected to the stage feeder 40 and the stage 100 retrieved through the stage retrieval unit 40' may be conveyed to the stage feeder 40. The stage feeder 40 may refeed the conveyed stage 100 to the stage feeding zone Z2.

The stage 100 may be conveyed on the base 10 from the stage feeding zone Z2 to the outlet zone Z7. The stage 100 may be conveyed from the stage feeding zone Z2 to a solar cell seating zone Z3. In the solar cell seating zone Z3, the solar cell C fed from the cell-jig feeder 90 may be seated on the stage 100 by the cell-jig conveying unit 91.

With the solar cell C seated on the stage 100, the stage 100 may be conveyed from the solar cell seating zone Z3 to a jig securing zone Z4. In the jig securing zone Z4, the solar cell C may be secured to the stage 100 as soon as the jig J is seated on the stage 100.

With the solar cell C and the jig J seated on the stage 100, the stage 100 may be conveyed from the jig securing zone Z4 to a pre-heating zone Z5. In the pre-heating zone Z5, the solar cell C seated on the stage 100 may be pre-heated through the first heater H1 disposed in the pre-heating zone Z5, prior to the curing process.

With the solar cell C and the jig J seated on the stage 100, the stage 100 may be conveyed from the pre-heating zone Z5 to the curing zone Z6. After entering the curing zone Z6, the solar cell C seated on the stage 100 may be subjected to the curing process.

After passing through the curing zone Z6, the stage 100 with the solar cell C and the jig J seated thereon may be conveyed to the outlet zone Z7. In the outlet zone Z7, the first heater H1 may be disposed to act as a temperature buffering feature to prevent the solar cell C from undergoing a sudden temperature change by slowly reducing a temperature of the solar cell C seated on the stage 100 when the stage 100 is discharged from a high temperature environment in the curing zone Z6.

The stage 100 may be conveyed to the stage retrieval unit 40' through the outlet zone Z7. Here, the jig J may be separated and retrieved from the stage 100 and the solar cell C through the jig retrieval unit 71. The jig retrieval unit 71 may be disposed in a region corresponding to the stage retrieval unit 40'. Accordingly, the jig retrieval unit 71 may retrieve the jig J disposed on the stage retrieval unit 40'. Alternatively, the jig retrieval unit 71 may be placed between the outlet zone Z7 and the stage retrieval unit 40'. Accordingly, the jig retrieval unit 71 may retrieve the jig J disposed in a region corresponding to a jig retrieval region.

In addition, the solar cell C seated on the stage 100 from which the jig J is retrieved may be separated and discharged from the stage 100 through the cell conveying unit 50. Then, the stage 100 may be delivered to the stage feeder 40 through the stage retrieval unit 40' and may be refed to the stage feeding zone Z2.

A wire feeder 30 may be disposed at one side of the stage feeding zone Z2. The wire feeder 30 may extend and convey wires w to the stage feeding zone Z2, the solar cell seating zone Z3, and the jig securing zone Z4 through a gripper to secure the wire w. Here, the extending wire w may be guided by a wire groove formed on the stage 100. Thus, the wire feeding zone Z1 may be a region including the wire feeder 30, the stage feeding zone Z2, the solar cell seating zone Z3, and the jig securing zone Z4.

The wires w may be disposed on upper and lower surfaces of the solar cell C. The wire w disposed on the lower surface of the solar cell C may be guided by the wire groove formed on the stage 100. The wire w disposed on the upper surface of the solar cell C may be secured thereto by the jig J by pressing the wire w onto the upper surface of the solar cell C. The jig J may secure the wire w such that the wire w does not lift or deviate from a specific location when connecting the wire w to the upper surface of the solar cell C.

The wire feeder 30 may include a cutter configured to cut a rolled wire to a preset first length and a gripper configured to extend and convey the wire of the first length to the jig securing zone Z4 through the stage feeding zone Z2 and the solar cell seating zone Z3.

Referring to FIG. 2, in order to perform the curing process, the stages 100 are fed to the stage feeding zone Z2 and the solar cell seating zone Z3 ((a) of FIG. 2) and, when a first wire w1 is fed by the wire feeder 30 ((b) of FIG. 2), the cell-jig conveying unit 91 simultaneously seats a pair of a first solar cell C1 and a first jig J1 on the first wire w1 ((C) of FIG. 2). At this time, the cell-jig conveying unit 91 seats the first solar cell C in the solar cell seating zone Z3 and seats the first jig J in the jig securing zone Z4.

Then, the stages 100, the first wire w1, the first jig J1, and the first solar cell C1 are conveyed on the base 10 to the curing zone Z6 by one pitch P and a second wire w is fed onto the conveyed solar cell C ((d) in FIG. 2).

Referring to FIG. 3, the pitch P may be a width P of the stage. Here, the pre-heating zone may have a width Z5 corresponding to the width P of the stage. Specifically, each of the width Z5 of the pre-heating zone and the width P of the stage may refer to a width in a direction parallel to a conveying direction of the solar cell C.

Then, the cell-jig conveying unit 91 simultaneously seats a pair of a second jig J2 and a second solar cell C2 on the second wire w2 ((e) of FIG. 2).

Referring again to FIG. 1, the jig and the solar cell on the stage 100 placed at the stage retrieval unit 40' are picked up to be separated from the stage 100 by the jig retrieval unit 71 and the cell conveying unit 50, respectively.

Then, the first wire w1, the first jig J1, the first solar cell C1, the second wire w2, the second jig J2, and the second solar cell C2 are conveyed on the base 10 to the curing zone Z6 by one pitch P and a third wire w3 is fed onto the conveyed solar cell C ((f) of FIG. 2).

Then, the cell-jig conveying unit 91 simultaneously seats a pair of a third jig J3 and a third solar cell C3 on the third wire w3 ((g) in FIG. 2). Referring again to FIG. 1, the jig and the solar cell on the stage 100 placed at the stage retrieval unit 40' are picked up and separated from the stage 100 by the jig retrieval unit 71 and the cell conveying unit 50, respectively.

In the above order, the wires w and the jigs J are disposed on the solar cells C on the stages 100 and the curing process may proceed in the curing zone Z6 with the wires w bonded to the upper and lower surfaces of the solar cell C.

The stage 100 may convey the solar cell C and the wire w disposed on the solar cell C to the curing zone Z6. The stage 100 may enter the curing zone Z6 through rails L formed on opposite sides of the base 10 and may exit the curing zone Z6 through the rails L. Referring to FIG. 3, a plurality of stages 100 may be continuously fed to the curing zone Z6 in a connected state.

The plurality of stages 100 may be provided with a plurality of solar cells C each having the wires w thereon, respectively. As shown in FIG. 2, a wire disposed on an upper surface of one solar cell C may extend to be disposed on a lower surface of another solar cell C connected to one solar cell C. In addition, a wire disposed on a lower surface of the one solar cell C may extend to be disposed on an upper surface of another solar cell C connected to the one solar cell C. Here, both the upper surface and the lower surface of one solar cell C may have the wires disposed thereon.

The base 10 on which the stage 100 is conveyed is formed in an elongated shape such that the stage 100 can be moved into the curing zone Z6 on the base 10. The stage 100 is formed at a lower end thereof with a guide G, which remains in a connected state with the rails L formed on the base 10 and allows the stage 100 to move along the rails L.

Between the rails L formed on the opposite sides of the base 10, two shafts SH may be formed parallel to the rails L. When the stage 100 is conveyed along the rails L, the stage 100 may be conveyed, with the lower end of the stage 100 contacting the shafts SH.

Each of the rails L extends from one end of the base 10 to the other end thereof in a longitudinal direction thereof. On the other hand, the shafts SH extend to pass through the pre-heating zone Z5, the curing zone Z6, and the outlet zone Z7.

According to this embodiment, the apparatus may further include a first heater H1 disposed between the two shafts SH on an upper surface of the base 10. In this embodiment, the first heater H1 is composed of three heaters and has a pipe structure extending in the longitudinal direction parallel to the shafts SH. However, it should be understood that the number and shape of the first heater H1 are not limited thereto.

The first heater H1 may have a length corresponding to the shafts SH. Thus, like the shafts SH, the first heater H1 extends through the pre-heating zone Z5, the curing zone Z6, and the outlet zone Z7. In this structure, a process of pre-heating the solar cell C may be performed in the pre-heating zone Z5, a process of curing the solar cell C may be performed in the curing zone Z6, and a process of relieving a temperature difference between the curing zone Z6 and the outside may be performed in the outlet zone Z7.

According to this embodiment, the first heater H1 may be a cartridge type heater.

The stage 100 having the solar cell C seated thereon may pass above the first heater H1. The first heater H1 may perform the curing process with respect to the solar cell C seated on the stage 100 while the stage 100 passes above the first heater H1.

The curing unit 20 is disposed above the base 10. The curing unit 20 is formed in a box shape open at a lower surface thereof. The curing unit 20 may be formed in an elongated shape in the longitudinal direction of the base 10 so as to cover a central portion of the base 10.

The curing unit 20 may be disposed to cover the curing zone Z6 of the base 10. However, in the event of failure or maintenance of the curing unit 20, the curing unit 20 may be opened to allow maintenance work to be performed on the interior of the curing unit 20.

A plurality of solar cells C disposed inside the curing unit 20 coupled to the central portion of the base 10 may be cured inside the curing unit 20, with each solar cell C seated on the corresponding stage 100. The curing unit 20 may be formed to accommodate as many stages 100 with the solar cells C seated thereon as possible in order to maximize the number of solar cells C to be cured.

Referring to FIG. 5, the curing unit 20 may be provided on an interior ceiling 21 thereof with a plurality of second heaters H2. According to this embodiment, the second heater H2 is composed of four heaters and has a pipe structure extending in a longitudinal direction parallel to the longitudinal direction of the curing unit 20. However, it should be understood that the number and shape of the second heater H2 are not limited thereto.

According to this embodiment, the second heater H2 may be an infrared (IR) heater.

Referring to FIG. 8, a first length L1 of the first heater H1 may be greater than a second length L2 of the second heater H2. The second heater H2 is disposed only in the curing zone Z6 and the first heater H1 having a greater length than the second heater H2 is disposed not only in the curing zone Z6 but also in the pre-heating zone Z5. The solar cell placed in the pre-heating zone Z5 is pre-heated by the first heater H1 in the pre-heating zone Z5 and may enter a curing space defined by the curing unit 20. In other words, the solar cell may enter the curing zone Z6 in a pre-heated state before the curing process, thereby improving quality of the cured solar cell C. Here, each of the first length L1 and the second length L2 refers to a length in a first direction, which is a length in a longitudinal axis direction of the first and second heaters H1, H2 corresponding to the conveying direction of the solar cells C on the base 10.

Here, the pre-heating zone Z5 may have a width corresponding to the width P of the stage. Thus, after being pre-heated in the pre-heating zone Z5, the stage 100 having the solar cell C seated thereon enters a space defined by the curing unit 20, and another stage 100 connected to the stage 100 that has entered the curing unit 20 is placed in the pre-heating zone Z5 such that another solar cell C seated on the other stage 100 can be pre-heated.

Referring to FIG. 5, the base may include the outlet zone Z7 to which the stage 100 having the solar cell C seated thereon is conveyed from the curing zone Z6. Here, the first heater H1 may be disposed in the curing zone Z6, the pre-heating zone Z5, and the outlet zone Z7. That is, the first heater H1 may extend beyond both ends of the second heater H2. After the curing process, the solar cell C conveyed out of the curing unit 20 may be subjected to post-heating by the first heater H1 in the outlet zone Z7. That is, the first heater H1 may be disposed in the outlet zone Z7 such that the solar cell C seated on in the stage 100 does not undergo a sudden temperature change when the stage 100 is conveyed from a high temperature environment in the curing zone Z6 to the outside of the curing zone Z6. The first heater H1 disposed in the outlet zone Z7 can play a temperature buffering role to slowly reduce the temperature of the solar cell C disposed on the stage 100. As a result, quality of the cured solar cell can be further improved.

Referring to FIG. 3 and FIG. 8, the solar cell seating zone Z3 according to this embodiment may have a width corresponding to the width P of the stage. Specifically, each of the width of the solar cell seating zone Z3 and the width P of the stage may refer to a width in a direction parallel to the conveying direction of the solar cell C.

The solar cell seating zone Z3 may be spaced apart from the pre-heating zone Z5 by a first distance D1. Here, the first distance D1 may refer to a length in the first direction corresponding to the conveying direction of the solar cell C. The first distance D1 may be greater than or equal to a length of the stage 100 in the first direction.

In the solar cell seating zone Z3, the solar cell C may be seated on the upper surface of the fed stage 100 from above the stage 100. The wires w fed from the wire feeder 30 described below are disposed on the upper surface of the stage 100 on which the solar cell C is seated, and on the lower surface of the solar cell C. The wire w fed onto the upper surface of the solar cell C may be joined to the upper surface of the solar cell C through contact therewith by the jig in the jig securing zone Z4.

In the pre-heating zone Z5, the first heater H1 for pre-heating is disposed. The solar cell seating zone Z3 may be included in the wire feeding zone Z1. In the solar cell seating zone Z3, not only the process of seating the solar cell C on the stage 100, but also the process of placing the wires w on the solar cell C through the wire feeder 30 in the wire supply zone Z1 may be performed. Therefore, if a heater is disposed in the solar cell seating zone Z3, the solar cell can be cured before the wire is placed in a predetermined location, thereby making it difficult for the wire to be joined to the solar cell through contact therewith.

According to this embodiment, the solar cell settling zone Z3 may be spaced apart from the pre-heating zone Z5 by the first distance D1 such that the curing process can be performed by the heater after the wire w is placed on the solar cell C.

According to this embodiment, the base 10 may further include the jig securing zone Z4, in which the jig J secures the upper surface of the solar cell C placed on the stage 100 to the stage 100.

The jig securing zone Z4 may have a width corresponding to the width P of the stage. Specifically, each of the width of the jig securing zone Z4 and the width P of the stage may refer to a width in the direction parallel to the conveying direction of the solar cell C.

The jig securing zone Z4 may be disposed between the pre-heating zone Z5 and the solar cell seating zone Z3.

In the pre-heating zone Z5, the first heater H1 for pre-heating is disposed. The jig securing zone Z4 may be included in the wire feeding zone Z1. In the jig securing zone Z4, a process in which the wire w of the solar cell C is pressed by the jig J and a process in which the wire w is placed on the solar cell C through the wire feeder 30 in the wire supply zone Z1 before the corresponding process may be performed.

The first heater H1 is not disposed in the jig securing zone Z4. If a heater is placed in the jig securing zone Z4, the solar cell can be cured before the wire is placed in a predetermined location, thereby making it difficult for the wire to be joined to the solar cell through contact therewith.

In the jig securing zone Z4, the jig J may be joined to the stage 100 to press the upper surface of the solar cell C seated on the upper surface of the stage 100. Here, the jig J may press the wire w disposed on the upper surface of the solar cell C to couple the wire w to the surface of the solar cell C through contact therewith.

The wire w disposed on the lower surface of the solar cell C may be joined to the lower surface of the solar cell C through contact therewith by a plurality of pins (not shown) inside the stage 100, which are lifted by the shafts SH disposed in the pre-heating zone Z5 and the curing zone Z6 as the stage 100 passes through the pre-heating zone Z5 and the curing zone Z6.

According to this embodiment, the base further includes the stage feeding zone Z2 in which the stage 100 is fed to the base 10. The stage feeding zone Z2 is connected to the solar cell seating zone Z3 and, in the stage feeding zone Z2, the stage feeder 40 may feed the stage 100 to the stage feeding zone Z2 while being lifted or lowered.

The stage feeding zone Z2 may be included in the wire feeding zone Z1. In the stage feeding zone Z2, not only the process of feeding the stages 100 to the stage feeding zone Z2, but also the process of placing the wires w on a plurality of grooves of the stage 100 through the wire feeder 30 in the wire supply zone Z1 may be performed. The stages 100 in the stage feeding zone Z2 may act to sequentially guide the wires w to the stage feeding zone Z2, the solar cell seating zone Z3, and the jig securing zone Z4 while the stages 100 are conveyed to the stage feeding zone Z2, the solar cell seating zone Z3, and the jig securing zone Z4.

The stage feeder 40 may pick up the stage 100 at the bottom of the stage feeding zone Z2 and then rise to reach a feeding location in the stage feeding zone Z2. Upon arrival at the stage feeding zone Z2, the stage 100 may be fed the wires w through the wire feeder 30. After the stage 100 receives the wires w, the stage 100 may sequentially move to the solar cell seating zone Z3 and the jig securing zone Z4 such that the wires w can be placed on the upper and lower surfaces of the solar cell C seated on the stage 100 while the stage 100 moves thereto.

According to this embodiment, the first heater H1 is spaced apart a first gap G1 from the solar cell C and the second heater H2 is spaced apart a second gap G2 from the solar cell C in the direction perpendicular to the solar cell C, in which the first gap G1 may be the sum of a first-1 gap G11 from the first heater H1 to the lower surface of the stage 100 and a second gap G12 from the lower surface of the stage 100 to the solar cell C.

The stage 100 may be spaced apart from the first heater H1 by the first-1 gap G11. The first-1 gap G11 allows heat supplied from the first heater H1 to be transferred to the stage 100.

In addition, since the solar cell C is disposed on the upper surface of the stage 100, the thickness of the stage 100, that is, the first-2 gap G12 from the lower surface of the stage 100 to the upper surface of the stage 100, is taken into account. Thus, the heat supplied from the first heater H1 may be transferred to the lower surface C1 of the solar cell C through a gas layer formed in the first gap G11 and a solid layer of the stage 100 formed in the second gap G12.

On the other hand, the second heater H2 is disposed above the solar cell C and heat supplied from the second heat H2 may be transferred to the upper surface C2 of the solar cell C through a gas layer formed in the second gap D2 between the solar cell C and the second heater H2.

According to this embodiment, since the solid layer has higher thermal conductivity than the gas layers, the distance of the first gap G1 including the solid layer between the first heater H1 and the solar cell C may be shorter than the distance of the second gap G2 consisting of the gas layer between the second heater H2 and the solar cell C for a uniform curing process on both surfaces of the solar cell C.

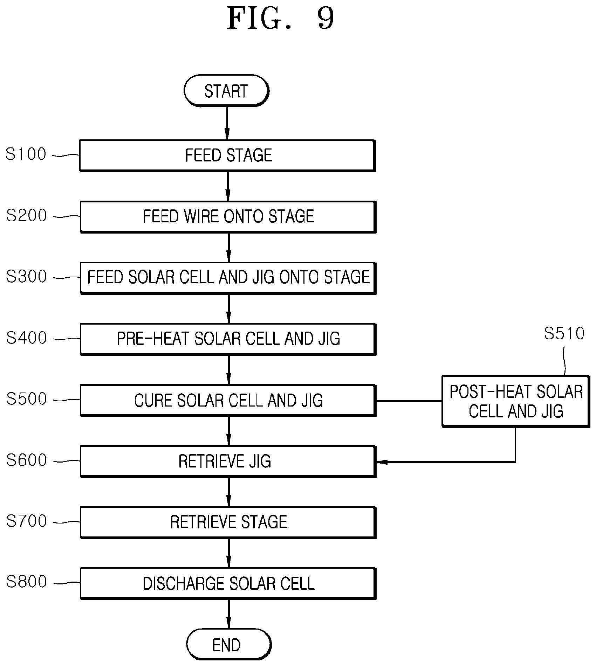

Next, a solar cell manufacturing method according to one embodiment of the present invention will be described with reference to FIG. 9. For details and description of components not shown in FIG. 9, refer to the details shown in FIG. 1 to FIG. 8 and description thereof.

FIG. 9 is a flowchart illustrating a solar cell manufacturing method according to one embodiment of the present invention.

Referring to FIG. 9, the solar cell manufacturing method according to the embodiment of the present invention may be performed while a stage 100 is moved by a preset pitch P at a time. For example, as the fed stage 100 is move by the preset pitch P, a wire w, a solar cell C, and a jig J may be disposed on the stage 100 such that processes, such as heating, curing, and discharge, may be sequentially carried out.

The solar cell manufacturing method according to the embodiment may include the steps of: feeding a stage (S100); feeding a wire onto the stage (S200); feeding a solar cell and a jig onto the stage (S300); pre-heating the solar cell and the jig (S400); curing the solar cell and the jig (S500); and discharging the solar cell (S800).

The step of feeding a stage (S100) may refer to the step of feeding the stage. For example, Step S100 may refer to a step in which the stage feeder 40 is raised and feeds a stage 100 to the stage feeding zone Z2. The stage 100 fed in the stage feeding step S100 may be conveyed by one pitch P at a time according to a process sequence.

The step of feeding a wire onto the stage (S200) may be performed after feeding the stage (S100). The step of feeding a wire onto the stage (S200) may refer to a step in which the wire feeder 30 feeds a wire w onto the stage 100. For example, Step S200 may refer to the step of feeding the wire onto the stages 100 placed in the solar cell seating zone Z3 and the jig securing zone Z4. Specifically, in Step S200, the wire feeder 30 may extend the wire w to the stage feeding zone Z2, the solar cell seating zone Z3, and the jig securing zone Z4 through the grippers. Here, the extending wire w may be guided by a wire groove formed on the stage 100.

The step of feeding a solar cell and a jig onto the stage (S300) may be performed after the step of feeding the wire onto the stage (S200). The step of feeding the solar cell and the jig onto the stage S300 may refer to the step of feeding the solar cell C and the jig J onto the stage 100 on which the wire w is disposed. For example, Step S300 may refer to the step of feeding the solar cell C onto the stage 100 disposed in the solar cell seating zone Z3 and the jig J onto the stage 100 disposed in the jig securing zone Z4. In Step S300, the solar cell C and the jig J may be simultaneously fed to the respective zones by the cell-jig conveying unit 91. Further, the wire w disposed on the solar cell C by the jig J fed in Step S300 may be secured thereto. That is, the wire w1, the solar cell C, the wire w2, and the jig may be sequentially disposed on the stage 100 in the jig securing zone Z4, as shown in (e) of FIG. 2.

The step of pre-heating the solar cell and the jig (S400) may be performed after the step of feeding the solar cell and the jig onto the stage (S300). The step of pre-heating the solar cell and the jig (S400) may refer to a step in which the solar cell C and the wire w disposed on the stage 100 are pre-heated by the first heater H1 in the pre-heating zone Z5. For example, as shown in (f) of FIG. 2, in Step S400, the solar cell C, and the lower and upper wires w1, w2 disposed respectively on the upper and lower surfaces of the solar cell C may be pre-heated by the first heater H1 in the pre-heating zone Z5. Here, the first heater H1 may be disposed on the upper surface of the base 10, which conveys and supports the stage 100 described above.

The step of curing the solar cell and the jig (S500) may be performed after the step of pre-heating the solar cell and the jig (S400). The step of curing the solar cell and the jig (S500) may refer to a step in which the solar cell C and the wires w disposed on the stage 100 are cured by the first and second heaters H1, H2 in the curing zone Z6. For example, in Step S500, the solar cell C and the lower and upper wires w1, w2 disposed respectively on the upper and lower surfaces of the solar cell C may be cured by the first and second heaters H1, H2 in the curing zone Z6. Here, the second heater H2 may be disposed inside the curing unit 20 disposed above the base 10 described above. The stage 100 may be conveyed between the first and second heaters H1, H2. Through Step S500, an electrically conductive adhesive (ECA) deposited on the upper and lower surfaces of the solar cell C may be cured, thereby allowing the wires w1 , w2 disposed on the upper and lower surfaces of the solar cell C to be physically and electrically connected to the solar cell C.

The step of discharging the solar cell (S800) may be performed after the step of cuing the solar cell and the jig (S500). In Step S800, the solar cell C having the wires w1, w2 connected to the upper and lower surfaces thereof may be discharged. For example, the solar cell C with the wires w1, w2 connected thereto may be separated and discharged from the stage 100 through the cell conveying unit 50.

The solar cell manufacturing method according to the embodiment of the present invention may further include the step of post-heating the solar cell and the jig (S510). The step of post-heating the solar cell and the jig (S510) may be performed between the step of curing the solar cell and the jig (S500) and the step of discharging the solar cell (S800). For example, Step S510 may refer to the step of post-heating the solar cell C, which has left the curing unit 20 after the curing step S500, with the first heater H1 in the outlet zone Z7. Step S510 may acts as a buffering step by slowly reducing the temperature of the solar cell C having left the curing unit 20 in the outlet zone Z7. Step S510 can prevent the cured solar cell C from undergoing a sudden temperature change, thereby further improving quality of the solar cell C.

The solar cell manufacturing method according to the embodiment of the present invention may further include the step of retrieving the jig (S600). The step of retrieving the jig (S600) may be performed between the step of curing the solar cell and the jig (S500) and the step of discharging the solar cell (S800). For example, Step S600 may refer to the step of retrieving the jig J placed on the stage 100 after the stage 100 passes through the curing zone Z6 and the outlet zone Z7. Specifically, in Step S600, the jig J disposed on the stage retrieval unit 40' may be separated and retrieved from the stage 100 and the solar cell C through the jig retrieval unit 71. Alternatively, Step S600 may refer to the step of retrieving the jig J disposed in a jig retrieval region (not shown) placed between the outlet zone Z7 and the stage retrieval unit 40'. Here, the jig retrieval unit 71 described above may be disposed in a region corresponding to the jig retrieval region.

The solar cell manufacturing method according to the embodiment of the present invention may further include the step of retrieving the stage (S700). The step of retrieving the stage (S700) may be performed between the step of curing the solar cell and the jig (S500) and the step of discharging the solar cell (S800). For example, Step S700 may refer to the step of retrieving the stage 100 disposed on the stage 100 that has passed through the curing zone Z6 and the outlet zone Z7. Specifically, in Step S700, the stage 100 may be retrieved through the stage retrieval unit 40'. The stage retrieval unit 40' is connected to the stage feeder 40, and the stage 100 retrieved through the stage retrieval unit 40' may be conveyed to the stage feeder 40. The stage feeder 40 may refeed the conveyed stage 100 to the stage feeding zone Z2.

As such, as the stage 100 is sequentially moved through the stage feeding zone Z2, the solar cell seating zone Z3, the jig securing zone Z4, the pre-heating zone Z5, the curing zone Z6, and the outlet zone Z7, the preparation and execution of the curing process with respect to the solar cell C may be performed in sequence.

That is, the processes, in which the wire w is fed to the stage 100, the solar cell C is disposed thereon, the wire w is disposed on both surfaces of the solar cell C, and the jig J presses the wire w disposed on the upper surface of the solar cell C, are sequentially carried out. Then, after the step of pre-heating the solar cell C through the first heater H1, the stage 100, on which the solar cell C with the wire w disposed thereon is seated, enters the curing zone Z6 defined by the curing unit 20 and is subjected to the curing process therein, whereby the curing process can be systematically and stably performed.

Furthermore, after the curing process is completed, the solar cell C conveyed out of the curing zone Z6 is subjected to post-heating in the outlet zone Z7, thereby preventing deformation or damage due to a sudden temperature change when the solar cell C is conveyed out of a high temperature environment to a low temperature environment. Furthermore, after the curing process is completed, the stages and the jigs used to convey the solar cells may be retrieved and refed, thereby enabling recycling of components.

Although the present invention has been described with reference to the embodiments and the drawings, it should be understood that these embodiments are provided by way of illustration only and that various modifications, changes, and alterations can be made without departing from the spirit and scope of the invention. The scope of the invention should be defined by the appended claims.

Specific technical details described in the embodiments are provided by way of example and do not limit the scope of the invention. In order to make the description of the invention concise and clear, descriptions of typical techniques and configurations in the art may be omitted. In addition, connections of lines or connection members between components shown in the drawings are given for illustration of functional connections and/or physical or circuit connections, which may be represented by various alternative or additional functional connections, physical connections, or circuit connections in an actual device. Furthermore, components may not be required for application of the present invention unless specifically stated as "essential," "important," or the like.

The word "the" or similar directives in the description and claims of the invention may refer to both singular and plural, unless otherwise specified. Furthermore, when a range is recited in an embodiment, it is intended to include the invention with individual values within the range (unless indicated otherwise) and means that each individual value constituting the range is recited in the description of the invention. In addition, the steps constituting a method according to an embodiment may be performed in any suitable order, unless an explicit order is stated or unless indicated otherwise. It should be understood that embodiments are not necessarily limited by the order in which the steps are described. The use of any examples or exemplary terms (for example, "and the like") in the embodiments is intended merely to describe the embodiments in detail and is not intended to limit the scope of the embodiments, unless limited by the claims. Furthermore, a person having ordinary knowledge in the art will recognize that various modifications, combinations, alterations, and changes can be made in accordance with design conditions and factors within the scope of the appended claims or equivalents thereto.

## Claims

1. A solar cell manufacturing apparatus comprising:
a base conveying a stage on which a solar cell is seated while supporting the stage; and
a curing unit disposed above the base and formed to have a hollow space open at a lower side thereof to partially cover an upper side of the base,
wherein the base comprises a first heater disposed on an upper surface thereof,
the curing unit comprises a second heater disposed on an interior ceiling of the curing unit,
the stage having the solar cell seated thereon is conveyed between the first heater and the second heater, and
a first length of the first heater is longer than a second length of the second heater,
each of the first and second lengths being a length in a first direction corresponding to a conveying direction of the solar cell.

2. The solar cell manufacturing apparatus according to claim 1, wherein
the base comprises:
a curing zone in which a curing process is performed with the solar cell seated on the stage; and
a pre-heating zone in which the stage having the solar cell seated thereon is pre-heated before entering the curing zone,
the first heater is disposed in the curing zone and in the pre-heating zone, and
the second heater is disposed in the curing zone.

3. The solar cell manufacturing apparatus according to claim 2, wherein
the base further comprises an outlet zone, to which the stage having the solar cell seated thereon is conveyed from the curing zone, and
the first heater is disposed in the curing zone, the pre-heating zone, and the outlet zone.

4. The solar cell manufacturing apparatus according to claim 2, wherein
the pre-heating zone has a width corresponding to a width of the stage.

5. The solar cell manufacturing apparatus according to claim 2, wherein
the base further comprises a solar cell seating zone in which the solar cell is seated on the stage,
the solar cell seating zone having a width corresponding to a width of the stage and being spaced apart from the pre-heating zone by a first distance.

6. The solar cell manufacturing apparatus according to claim 5, wherein
the base further comprises a jig securing zone in which an upper surface of the solar cell seated on the stage is secured to the stage by a jig,
the jig securing zone having a width corresponding to a width of the stage and being disposed between the pre-heating zone and the solar cell seating zone.

7. The solar cell manufacturing apparatus according to claim 5, wherein
the base further comprises a stage feeding zone in which the stage is fed to the base,
the stage feeding zone being connected to the solar cell seating zone, and
a stage feeder feeds the stage to the stage feeding zone while being lifted or lowered in the stage feeding zone.

8. The solar cell manufacturing apparatus according to claim 7, wherein
the base further comprises a wire feeding zone in which a wire is fed to the stage feeding zone and the solar cell seating zone,
the wire feeding zone being provided with a wire feeder to feed the wire to the stage in the stage feeding zone.

9. The solar cell manufacturing apparatus according to claim 1, wherein
the first heater is disposed at a location facing a lower surface of the solar cell to cure the lower surface of the solar cell, and
the second heater is disposed at a location facing an upper surface of the solar cell to cure the upper surface of the solar cell.

10. A solar cell manufacturing method comprising:
feeding a stage to a solar cell manufacturing apparatus;
feeding a wire onto the stage;
feeding a solar cell and a jig onto the stage fed the wire;
pre-heating the solar cell and the jig on the stage;
curing the solar cell and the jig on the stage; and
discharging the solar cell.

11. The solar cell manufacturing method according to claim 10, wherein the solar cell manufacturing apparatus comprises:
a base conveying the stage while supporting the stage and comprising a first heater disposed on an upper surface thereof; and
a curing unit comprising a second heater,
the stage is conveyed between the first heater and the second heater,
the solar cell and the jig are pre-heated by the first heater in the step of pre-heating, and
the solar cell and the jig are cured by the first and second heaters in the step of curing.

12. The solar cell manufacturing method according to claim 10, further comprising:
post-heating the solar cell and the jig on the stage after the step of curing.

13. The solar cell manufacturing method according to claim 10, further comprising:
retrieving the jig after the step of post-heating.

14. The solar cell manufacturing method according to claim 10, further comprising:
retrieving the stage after the step of post-heating.
